# EUROPEAN PATENT APPLICATION

(11) **EP 4 380 336 A1**
(43) Date of publication of application: **05.06.2024**
(21) Application number: 21806121.6
(22) Date of filing: 18.08.2021
(51) Int. Cl.: H10K 39/00, H10K 65/00, H10K 71/00

(54) **ORGANIC LIGHT-EMITTING DISPLAY DEVICE AND MANUFACTURING METHOD**

(30) Priority: 30.07.2021 CN 202110874384
(71) Applicant: TCL CHINA STAR OPTOELECTRONICS TECHNOLOGY CO., LTD., Shenzhen, Guangdong 518132 (CN)
(72) Inventor: REN, Xuechao, Guangdong 518132 (CN)
(74) Representative: Murgitroyd & Company
(86) International application number: PCT/CN2021/113183
(87) International publication number: WO 2023/004896

(57) **Abstract**

An organic light-emitting display device and a method of manufacturing the same are disclosed. The organic light-emitting display device includes a light-shielding layer, a transparent first touch electrode spaced apart from the light-shielding layer on a surface of the substrate on which the light-shielding layer is disposed, a buffer layer, and an active layer disposed on the buffer layer and including a channel portion and a transparent second touch electrode. A touch device formed by the transparent first touch electrode and the second touch electrode will not affect light transmittance of a display device.

## Description

### BACKGROUND OF INVENTION

### 1. FIELD OF INVENTION

The present invention relates to a technical field of displays, and more particularly to an organic light-emitting display device and a method of manufacturing the same.

### 2. RELATED ART

With rapid development of display technologies, touch display panels, as the simplest and most convenient way of human-computer interaction, have been widely used in most electronic products, such as mobile phones, tablets, laptops, monitors, televisions, and so on.

Touch technologies of current organic light-emitting diode (OLED) display panels generally use on-cell touch technologies. That is, touch sensors are attached to the OLED display panels to enable touch functions of display panels. Touch electrodes of on-cell touch OLED display panels in a horizontal direction and in a vertical direction are arranged above light-emitting layers of the display panels. As a result, at an intersection of the horizontal and vertical touch electrodes, due to shielding caused by the two layers of the touch electrodes, brightness of pixels at where the shielding occurs will be significantly lower than brightness of other pixels, resulting in uneven brightness of the display panels. In addition, staggered arrangements of the horizontal and vertical touch electrodes have a greater impact on light extraction efficiency. Therefore, for display devices, aperture ratios are relatively low, and such a touch electrode structure will be accompanied by moire fringes, thereby adversely affecting display effects, and thickness of devices is further increased because of laminated touch sensors.

### SUMMARY OF INVENTION

An object of the present application is to provide an organic light-emitting display device and a method of manufacturing the same to solve a technical problem of low aperture ratios, greater thickness of devices, pool light output efficiency, uneven brightness, and poor display effects with current touch organic light-emitting display panels due to provision of touch devices.

To achieve the above-mentioned object, the present application provides a technical solution as follows:

An embodiment of the present application provides an organic light-emitting display device, comprising a substrate comprising a plurality of pixel units, each of the pixel units comprising a thin-film transistor and an organic light-emitting diode (OLED) display device, the thin-film transistor comprising a channel portion, a gate electrode, and a source/drain electrode, wherein the organic light-emitting display device further comprises a light-shielding layer disposed on the substrate and located under the thin-film transistor and electrically connected to the thin-film transistor; at least a first touch electrode, being transparent, and spaced apart from the light-shielding layer on a same surface of the substrate; a buffer layer covering the light-shielding layer and the first touch electrode; and an active layer disposed on the buffer layer and comprising the channel portion of the thin-film transistor and at least a second touch electrode spaced apart from the channel portion, wherein the second touch electrode is disposed opposite to the first touch electrode and is transparent.

Optionally, the organic light-emitting display device further comprises a functional film layer and a pixel definition layer disposed on the functional film layer, the functional film layer disposed on the buffer layer and covering the thin-film transistor and the second touch electrode, wherein the organic light-emitting diode display device comprises a lower electrode layer, an organic light-emitting module, and an upper electrode layer disposed sequentially from bottom to top, wherein the lower electrode layer is located on a surface of the functional film layer away from the substrate and is electrically connected to the source electrode of the thin-film transistor, and light emitted by the organic light-emitting diode display device is emitted in a direction toward the substrate.

Optionally, the lower electrode layer is a transparent cathode layer, the upper electrode layer is an anode layer, and the lower electrode layer is connected to the light-shielding layer through the source electrode, wherein an orthographic projection of the light-shielding layer on the substrate covers orthographic projections of the channel portion and the source electrode on the substrate.

Optionally, the channel portion of the thin-film transistor comprises a semiconductor channel and contact portions located at two ends of the semiconductor channel, a gate insulating layer is disposed on a side of the semiconductor channel away from the buffer layer, and the gate electrode is disposed on the gate insulating layer, wherein the drain electrode is connected to one of the contact portions, and the source electrode is connected to the other contact portion.

Optionally, the organic light-emitting display device further comprises a plurality of the first touch electrodes and a plurality of the second touch electrodes, and the pixel units are arranged in an array, wherein the first touch electrodes are arranged in rows and the second touch electrodes are arranged in columns.

Optionally, there are at least two of the pixel units configured between adjacent rows of the first touch electrodes, and/or there are at least two of the pixel units configured between adjacent columns of the second touch electrodes.

An embodiment of the present application further provides a method of manufacturing an organic light-emitting display device, comprising forming a plurality of pixel units arranged in an array on a substrate, and each of the pixel units comprises a thin-film transistor and an organic light-emitting diode display device, wherein the manufacturing method further comprises forming a light-shielding layer on the substrate; forming, using a transparent metal material, at least a first touch electrode spaced apart from the light-shielding layer on a surface of the substrate provided with the light-shielding layer; forming a buffer layer on the substrate such that the buffer layer covers the light-shielding layer and the first touch electrode; depositing an active layer on the buffer layer and patterning the active layer to form a channel portion and a touch area corresponding to the first touch electrode; forming a second touch electrode in the active layer corresponding to the touch area, and forming a semiconductor channel and contact portions in the channel portion; forming a functional film layer and the thin-film transistor on the buffer layer provided with the second touch electrode and the channel portion; and forming a pixel definition layer and the organic light-emitting diode display device on the functional film layer.

Optionally, the step of forming the second touch electrode in the active layer corresponding to the touch area comprises performing an electrically conductive treatment on a portion of the active layer corresponding to the touch area by a dry process to form the second touch electrode; wherein the step of forming the functional film layer and the thin-film transistor on the buffer layer provided with the second touch electrode and the channel portion comprises: forming a plurality of contact holes in the functional film layer, so that a source electrode included in the thin-film transistor is connected to the light-shielding layer through one of the contact holes, and a drain electrode and the source electrode included in the thin-film transistor are connected to two ends of the channel portion through the other contact holes.

Optionally, the step of forming the pixel definition layer and the organic light-emitting diode display device on the functional film layer comprises forming a via hole in the functional film layer, and the via hole extending through part of the functional film layer to the source electrode of the thin-film transistor; forming a transparent lower electrode layer on a surface of the functional film layer away from the substrate, wherein the lower electrode is connected to the source electrode of the thin-film transistor through the via hole; forming an organic light-emitting module on the lower electrode layer; and forming an upper electrode layer on the organic light-emitting module; wherein the organic light-emitting diode display device is controlled by the thin-film transistor to emit light in a direction toward the substrate.

Optionally, the method of manufacturing the organic light-emitting display device further comprises forming a plurality of the first touch electrodes arranged in rows; and forming a plurality of the second touch electrodes arranged in columns; wherein there are at least two of the pixel units configured between adjacent rows of the first touch electrodes, and/or there are at least two of the pixel units configured between adjacent columns of the second touch electrodes.

In the organic light-emitting display device and the method of manufacturing the same provided by the embodiments of the present application, a first touch electrode is disposed on a side of a substrate functioning as a light-emitting surface, and a second touch electrode and an active layer are disposed in a same layer. By using a transparent capacitor structure in the OLED display device as a touch device, not only can the need for additional masks for making touch electrodes be prevented, and since a mutual-capacitive touch device is located close to the light-emitting surface, interference from other electrical signals to a touch signal can be greatly reduced. In addition, integrating the touch device in the OLED display device improves a touch effect of the in-cell touch OLED display device. Furthermore, the first touch electrode and the second touch electrode made of transparent materials will not affect the light transmittance of the touch display device, thereby increasing an aperture ratio of the touch display device, maintaining high display performance of the display device, and reducing thickness of the display device, thereby effectively overcoming a technical problem of low aperture ratios, greater thickness of devices, pool light output efficiency, uneven brightness, and poor display effects with current touch organic light-emitting display panels due to provision of touch devices.

The present application has advantageous effects as follows: in the organic light-emitting display device and the method of manufacturing the same provided by the embodiments of the present application, a first touch electrode is disposed on a side of a substrate functioning as a light-emitting surface, and a second touch electrode and an active layer are disposed in a same layer. By using a transparent capacitor structure in the OLED display device as a touch device, not only can the need for additional masks for making touch electrodes be prevented, and since a mutual-capacitive touch device is located close to the light-emitting surface, interference from other electrical signals to a touch signal can be greatly reduced. In addition, integrating the touch device in the OLED display device improves a touch effect of the in-cell touch OLED display device. Furthermore, the first touch electrode and the second touch electrode made of transparent materials will not affect the light transmittance of the touch display device, thereby increasing an aperture ratio of the touch display device, maintaining high display performance of the display device, and reducing thickness of the display device, thereby effectively overcoming a technical problem of low aperture ratios, greater thickness of devices, pool light output efficiency, uneven brightness, and poor display effects with current touch organic light-emitting display panels due to provision of touch devices.

### BRIEF DESCRIPTION OF DRAWINGS

To describe the technical solutions in the embodiments of the present invention, the following briefly introduces the accompanying drawings for describing the embodiments. Apparently, the accompanying drawings in the following description show merely some embodiments of the present invention, and a person skilled in the art may still derive other drawings from these accompanying drawings without creative efforts.
FIG. 1 is a schematic cross-sectional view of an organic light-emitting display device of an embodiment of the present application.
FIG. 2 is a schematic view of touch electrode wirings of an embodiment of the present application.
FIG. 3 is another schematic cross-sectional view of the organic light-emitting display device of an embodiment of the present application.
FIG. 4 is a flowchart of a method of manufacturing an organic light-emitting display device of an embodiment of the present application.
FIGs. 5 to 11 are schematic views of film layer structures of a display device fabricated in each step in the method of manufacturing the organic light-emitting display device according to the embodiment of the present application.

### DESCRIPTION OF PREFERRED EMBODIMENTS

The following embodiments are referring to the accompanying drawings for exemplifying specific implementable embodiments of the present invention. Directional terms described by the present invention, such as upper, lower, front, back, left, right, inner, outer, side, etc., are only directions by referring to the accompanying drawings, and thus the used directional terms are used to describe and understand the present invention, but the present invention is not limited thereto. In the drawings, units with similar structures are indicated by the same reference numerals. In the drawings, for clear understanding and ease of description, the thickness of some layers and regions are exaggerated. That is, the size and thickness of each component shown in the drawings are arbitrarily shown, but the application is not limited to them.

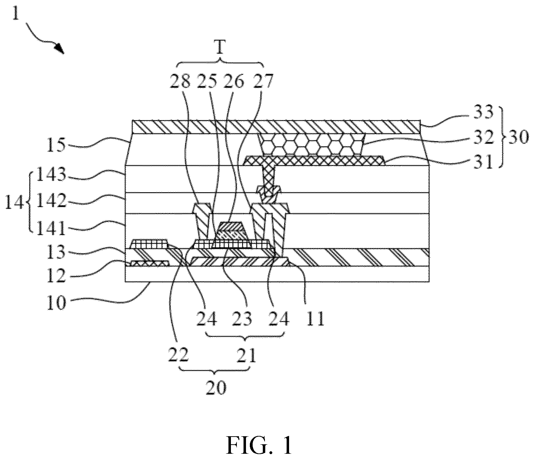

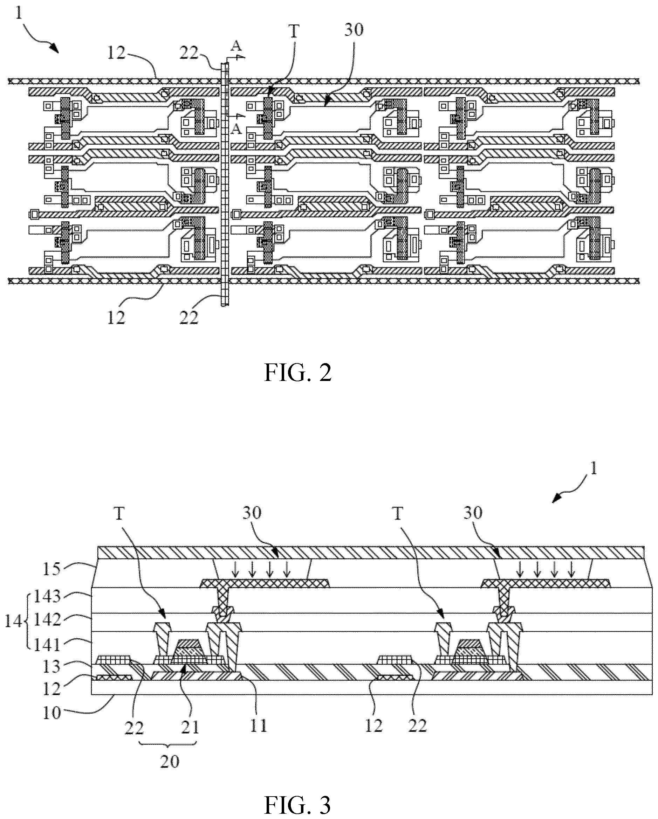

An embodiment of the present application provides an organic light-emitting diode (OLED) display device, particularly an OLED display device with an in-cell touch structure. Please refer to FIGs. 1 and 2. FIG. 1 is a schematic cross-sectional view of an organic light-emitting display device taken along line A-A of FIG. 2 according to an embodiment of the present application, and FIG. 2 is a schematic view of touch electrode wirings of the embodiment of the present application. As shown in FIG. 1, the organic light-emitting display device 1 of the present application includes a laminated structure formed by a substrate 10, a light-shielding layer 11, a first touch electrode 12, a buffer layer 13, an active layer 20 having a channel portion 21 and a second touch electrode 22, a thin-film transistor T, a functional film layer 14, a pixel defining layer 15, and an organic light-emitting diode display device 30. It should be noted that the substrate 10 of the organic light-emitting display device 1 includes a plurality of pixel units arranged in an array (as shown in FIG. 2). Each of the pixel units includes a thin-film transistor T and an organic light-emitting diode display device 30. The organic light-emitting display device 1 of FIG. 1 is illustrated by taking a single pixel unit as an example.

Referring to FIG. 1, the substrate 10 serves as a bottom surface of the laminated structure. The substrate 10 may be made of a material, such as glass or transparent plastic, and preferably glass. the light-shielding layer 11 is disposed on the surface of the substrate 10. Specifically, a metal light-shielding material is deposited on a surface of the substrate 10 by a sputtering physical vapor deposition process. Then, a wet etching process may be used to pattern the metal light-shielding material to form the light-shielding layer 11. Specifically, a material of the light-shielding layer 11 can be a metal material, such as aluminum, molybdenum, aluminum, or titanium dioxide, and is not limited thereto.

Further, a transparent metal material is deposited by a physical vapor deposition process on the surface of the substrate 10 provided with the light-shielding layer 11, and then the transparent metal material is patterned by a photolithography process including exposure, development, and etching to form the first touch electrode 12. In this embodiment of the present application, the first touch electrode 12 is made of transparent indium tin oxide (ITO). Specifically, the first touch electrode 12 and the light-shielding layer 11 are spaced apart from each other on the same surface of the substrate 10. Then, the buffer layer 13 is deposited on the substrate 10 to cover the light-shielding layer 11 and the first touch electrode 12. Specifically, the buffer layer 13 may be made of a material, such as nitride (silicon nitride, etc.), oxide (silicon oxide, silicon dioxide) ,or other insulating materials.

As shown in FIG. 1, the active layer 20 is disposed on the buffer layer 13. The active layer 20 is patterned by a photolithography process, so that the active layer 20 forms a channel portion 21 and a second touch electrode 22 spaced apart from the channel portion 21. Specifically, the active layer 20 may be a transparent metal oxide semiconductor made of indium gallium zinc oxide (IGZO). Further, the channel portion 21 is disposed directly above the light-shielding layer 11 and includes a semiconductor channel 23 and contact portions 24 located at two ends of the semiconductor channel 23. It should be noted that the contact portions 24 and the second touch electrode 22 are formed by performing an electrically conductive treatment through a dry process. In practical applications, the patterning of the channel portion 21 and the second touch electrode 22 is fulfilled by exposure and development processes using a halftone mask (not shown). After that, conductorization of the contact portions 24 and the second touch electrode 22 can be achieved by a dry process, that is, an ion doping process or a plasma surface treatment process. Resistivity of part of the active layer 20 (i.e., the contact portions 24 and the second touch electrode 22) that undergoes the electrically conductive treatment (also referred to as conductorization) can be reduced, thereby increasing conductivity. Further, the contact portions 24 on both ends of the channel portion 21 are configured to contact the source/drain electrode of the thin-film transistor T. It should be noted that the second touch electrode 22 of the embodiment of the present application is disposed above the first touch electrode 12 with respect to the buffer layer 13, and forms an overlapping area with the first touch electrode 12. Specifically, the first touch electrode 12 is made of transparent ITO and the second touch electrode 22 is made of transparent IGZO. Transparent material properties of ITO and IGZO will not adversely affect light transmittance of a display device.

Continuing referring to FIG. 1, on the basis of the second touch electrode 22 and the channel portion 21 provided on the substrate 10, a gate insulating layer 25, a gate electrode 26, the functional film layer 14, a source electrode 27, a drain electrode 28, the organic light-emitting diode display device 30, and the pixel definition layer 15 are sequentially formed. It should be noted that the channel portion 21, the gate insulating layer 25, the gate electrode 26, the source electrode 27, and the drain electrode 28 of the active layer 20 together constitute the thin-film transistor T. As shown in FIG. 1, the gate electrode 26 is disposed above the channel portion 21, that is, the thin-film transistor T in the embodiment of the present application is a top-gate thin-film transistor. Specifically, there is no overlapping area between the gate electrode and the source/drain electrode, which can effectively reduce parasitic capacitance between the gate electrode and the source/drain electrode, thereby achieving a higher resolution OLED display. The functional film layer 14 includes an interlayer dielectric layer 141, a passivation layer 142, and a planarization layer 143 disposed on the buffer layer 13. Specifically, the source electrode 27 and the drain electrode 28 are located on a surface of the interlayer dielectric layer 141 away from the active layer 20 and are electrically connected to the contact portions 24 on the two ends of the semiconductor channel 23 through contact holes formed in the interlayer dielectric layer 141, respectively. Furthermore, another contact hole is further formed in the interlayer dielectric layer 141 to extend through the interlayer dielectric layer 141 and part of the buffer layer 13 for allowing the source electrode 27 to connect to the light-shielding layer 11. The passivation layer 142 is formed on the interlayer dielectric layer 141 and covers the source electrode 27 and the drain electrode 28. The planarization layer 143 is disposed on the passivation layer 142. The organic light-emitting diode display device 30 is connected to the source electrode 27 through a via hole formed in the planarization layer 143. Functions of each of the above-mentioned layers of the functional film layer 14 are substantially the same as those of a general organic light-emitting display device, and will not be repeated here. In addition, a thin-film encapsulation layer and a protective film layer (not shown) are also provided on the organic light-emitting diode display device 30 to protect the device and block intrusion of external moisture.

As shown in FIG. 1, the organic light-emitting diode display device 30 of the embodiment of the present application includes a lower electrode layer 31, an organic light-emitting module 32, and an upper electrode layer 33 disposed in sequence from bottom to top. In addition, the lower electrode layer 31 is provided on a surface of the functional film layer 14 away from the substrate 10 and is electrically connected to the source electrode 27 of the thin-film transistor T, and is then connected to the light-shielding layer 11 through the source electrode 27. Specifically, the organic light-emitting module 32 at least includes a hole transport layer, an organic light-emitting layer, and an electron transport layer (not shown). It should be noted that the lower electrode layer 31 is a transparent cathode layer, which can be a transparent ITO layer. The upper electrode layer 33 is an anode layer, made of a material, such as magnesium or silver. The OLED display device 30 of the embodiment of the present application is controlled by the thin-film transistor T. Specifically, when a current is applied to the OLED display device 30, electrons and holes move through the layers of the OLED display device 30, and finally meet and combine in the organic light-emitting layer, thereby generating excitons to emit light, and the light is directed in a direction toward the glass substrate 10 (as shown in FIG. 3). That is, the organic light-emitting display device 1 of the embodiment of the present application is a bottom emission type organic light-emitting display device.

It should be noted that, since the thin-film transistor T in the embodiment of the present application is arranged on a side of a light-emitting surface, electrical stability of the thin-film transistor T is susceptible to light irradiation. Therefore, the light-shielding layer 11 is provided under the thin-film transistor T in the embodiment of the present application, which prevents the electrical stability of the thin-film transistor T from being adversely affected by light. Specifically, an orthographic projection area of the light-shielding layer 11 on the substrate 10 covers an orthographic projection area of the channel portion 21 and the source electrode 27 on the substrate 10 to effectively prevent the influence of external light.

Please refer to FIGs. 2 and 3. FIG. 3 is another schematic cross-sectional view of the organic light-emitting display device 1 taken along line A-A of FIG. 2 according to an embodiment of the present application. The organic light-emitting display device 1 shown in FIGs. 2 and 3 includes a plurality of pixel units arranged in an array. In an embodiment of the present application, a plurality of the first touch electrodes 12 are arranged in rows, a plurality of the second touch electrodes 22 are arranged in columns (as shown in FIG. 2), and the first touch electrode 12 and the second touch electrode 22 are electrically connected to a touch chip (not shown). One of the first touch electrode 12 or the second touch electrode 22 serves as a driving electrode (in this embodiment, the second touch electrode 22 is the driving electrodes), and the other one serves as a sensing electrode (that is, the first touch electrode 12). Specifically, the two form an overlapping area with respect to the buffer layer 13 such that the first touch electrode 12 and the second touch electrode 22 are arranged to cross each other to form a mutual-capacitive touch device. When an external finger touches a screen, a capacitance at an intersection of the first touch electrode 12 and the second touch electrode 22 will change, so that a capacitance change signal is received by a sensing electrode wiring, thereby determining a touch position.

In the organic light-emitting display device 1 of the embodiment of the present application, the first touch electrode 12 is disposed on a side of the substrate 10 functioning as a light-emitting surface, and the second touch electrode 22 is disposed on the same layer as the active layer 20. Using the transparent capacitor structure in the OLED display device as a touch device not only can prevent the need for additional masks for making touch electrodes, and since the mutual-capacitive touch device is located close to the light-emitting surface, interference of the touch signal from other electrical signals can be greatly reduced. In addition, integrating a touch device in the OLED display device 1 improves a touch effect of the in-cell touch OLED display device. Furthermore, the first touch electrode 12 and the second touch electrode 22 made of transparent materials will not affect the light transmittance of the touch display device, thereby increasing an aperture ratio of the touch display device, maintaining high display performance of the display device, and reducing thickness of the display device.

It should be noted that since the touch device of the embodiment of the present application is integrated between the pixel units of the OLED display device 1, the arrangement of the first touch electrodes 12 and the second touch electrodes 22 can be changed according to the arrangement of the pixel units. Specifically, for a large-sized display device, touch accuracy only needs to be within a range of 0.5 centimeters (cm) x 0.5 cm to ensure an effective touch effect, while an area of a pixel unit as required is actually only a micron level. Therefore, because the touch device formed by the first touch electrode 12 and the second touch electrode 22 in the embodiment of the present application is integrated between the pixel units in the OLED display device 1, in this application, wirings of the first touch electrode 12 and the second touch electrode 22 can be designed according to product characteristics. Specifically, the touch device of the present application can be arranged across pixels to reduce an area as originally needed for touch electrode wirings. In one embodiment, there are at least two pixel units configured between adj acent rows of the first touch electrodes 12, and/or there are at least two pixel units configured between adjacent columns of the second touch electrodes 22. In another embodiment, one row of the first touch electrode 12 may be arranged between the plurality of the pixel units, or one row of the first touch electrodes 12 may be arranged between any adjacent ones of the pixel units (as shown in FIG. 3). Likewise, one row of the second touch electrode 22 may be arranged between the plurality of the pixel units, or one row of the second touch electrodes 22 may be arranged between any adjacent ones of the pixel units (as shown in FIG. 3), and other different arrangements will not be repeated.

An embodiment of the present application further provides a method of manufacturing an organic light-emitting display device, that is, a method of manufacturing the organic light-emitting display device 1 of the foregoing embodiments.

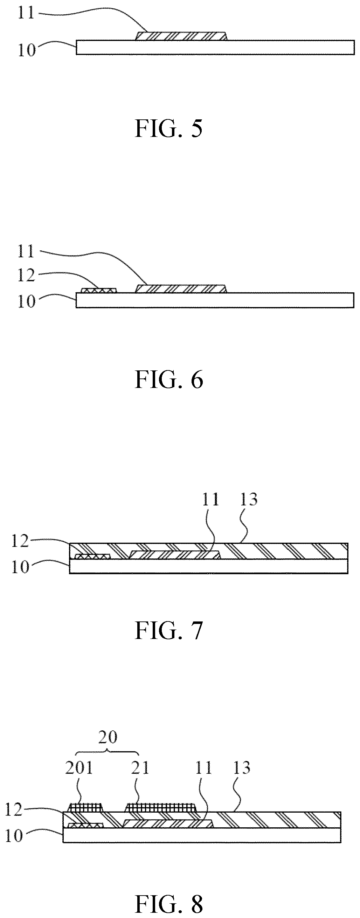

Referring to FIGs. 4, 5 to 11, FIG. 4 is a flowchart of the method of manufacturing the organic light-emitting display device of the embodiment of the present application. FIGs. 5 to 11 are schematic views of film layer structures of a display device fabricated in each step in the method of manufacturing the organic light-emitting display device according to the embodiment of the present application.

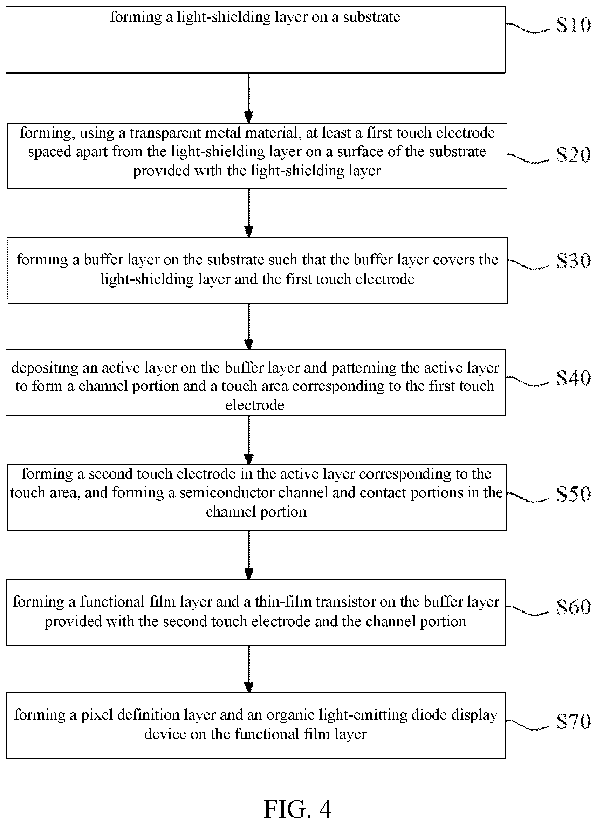

As shown in FIG. 4, the method of manufacturing the organic light-emitting display device 1 of the embodiment of the present application includes steps S10 to S70:

Step S10: forming a light-shielding layer on a substrate. Specifically, as shown in FIG. 5, a material of the substrate 10 may be, for example, glass or transparent plastic, and preferably glass. A metal light-shielding material is deposited on a surface of the substrate 10 by a sputtering physical vapor deposition process. Then, a wet etching process is used to pattern the metal light-shielding material to form the light-shielding layer 11.

Step S20: forming, using a transparent metal material, at least a first touch electrode spaced apart from the light-shielding layer on a surface of the substrate provided with the light-shielding layer. Specifically, as shown in FIG. 6, transparent ITO is deposited by a physical vapor deposition process on the surface of the substrate 10 provided with the light-shielding layer 11, and then the transparent ITO is patterned by a photolithography process including exposure, development, and etching to form the first touch electrode 12.

Step S30: forming a buffer layer on the substrate such that the buffer layer covers the light-shielding layer and the first touch electrode. Specifically, as shown in FIG. 7, a chemical vapor deposition method is used to deposit, for example, nitride (silicon nitride, etc.), oxide (silicon oxide, silicon dioxide), or other insulating materials on the substrate 10 to cover the light-shielding layer 11 and the first touch electrode 12.

Step 40: depositing an active layer on the buffer layer and patterning the active layer to form a channel portion and a touch area 201 corresponding to the first touch electrode. Specifically, as shown in FIG. 8, a transparent metal oxide semiconductor material is continuously deposited on the buffer layer 13 to form an active layer 20, wherein the metal oxide semiconductor material may be indium gallium zinc oxide (IGZO). The active layer 20 is patterned by a photolithography process, so that the active layer 20 is formed into a channel portion 21 and the touch area 201 spaced apart from the channel portion 21, wherein the channel portion 21 is disposed directly above the light-shielding layer 11. It should be noted that the patterning of the channel portion 21 and the touch area 201 is fulfilled by exposure and development processes using a halftone mask (not shown).

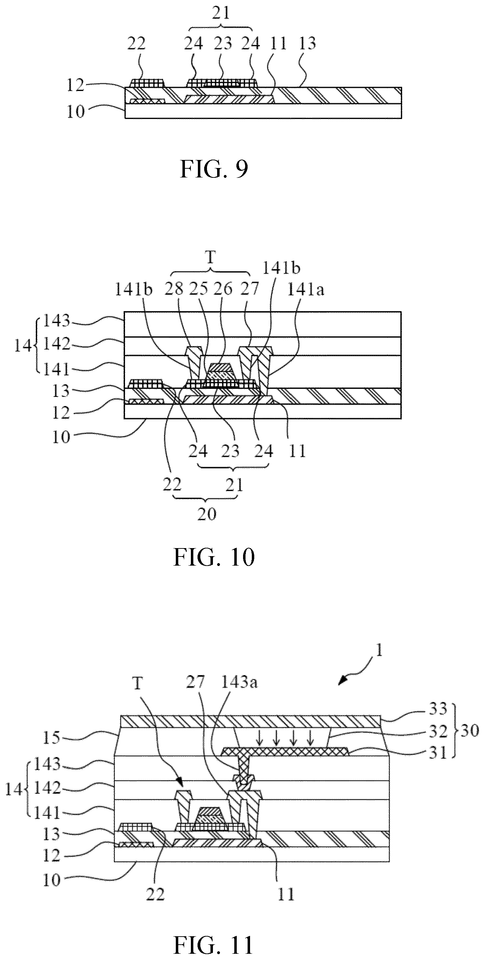

Step S50: forming a second touch electrode in the active layer corresponding to the touch area, and forming a semiconductor channel and contact portions in the channel portion. Specifically, as shown in FIG. 9, the channel portion 21 includes a semiconductor channel 23 and contact portions 24 located on two sides of the semiconductor channel 23, wherein the second touch electrode 22 and the contact portions 24 are formed by performing an electrically conductive treatment through a dry process, that is, the semiconductor channel 23 of the active layer 20 between the two contact portions 24 is not being electrically conductorized.

Step S60: forming a functional film layer and a thin-film transistor on the buffer layer provided with the second touch electrode and the channel portion. Specifically, as shown in FIG. 10, a gate insulating layer 25, a gate electrode 26, a functional film layer 14, a source electrode 27, and a drain electrode 28 are sequentially formed on the buffer layer 13. It should be noted that the channel portion 21, the gate insulating layer 25, the gate electrode 26, the source electrode 27, and the drain electrode 28 of the active layer 20 together constitute the thin-film transistor T. In addition, the functional film layer 14 includes an interlayer dielectric layer 141, a passivation layer 142, and a planarization layer 143 sequentially disposed from bottom to up.

Step S70: forming a pixel definition layer and an organic light-emitting diode display device on the functional film layer. Specifically, as shown in FIG. 11, an organic light-emitting diode display device 30 and a pixel definition layer 15 are formed on a surface of the planarization layer 143 away from the substrate 10. The manufacturing of the organic light-emitting display device 1 of the embodiment of the present application can be completed by the above steps. Specifically, in the embodiment of the present application, a plurality of pixel units arranged in an array are formed on the substrate 10, and each pixel unit includes the thin-film transistor T and the organic light-emitting diode display device 30.

Furthermore, as shown in FIG. 10, the step of forming the functional film layer and the thin-film transistor on the buffer layer provided with the second touch electrode and the channel portion includes: forming a plurality of contact holes 141a and 141b in the functional film layer 14, so that the source electrode 27 of the thin-film transistor T is connected to the light-shielding layer 11 through the contact hole 141a, and the drain electrode 28 and the source electrode 27 of the thin-film transistor T are connected to two ends of the channel portion 21 through the other contact holes 141b.

Furthermore, as shown in FIG. 11, the step of forming the pixel definition layer and the organic light-emitting diode display device on the surface of the functional film layer away from the substrate includes: forming a via hole 143a in the functional film layer 14 such that the via hole 143 extends through part of the functional film layer 14 to the source electrode 27 of the thin-film transistor T; forming a transparent lower electrode layer 31 on the surface of the functional film layer 14 away from the substrate 10 (that is, a surface of the planarization layer 143), wherein the lower electrode 31 is connected to the source electrode 27 of the thin-film transistor T through the via hole 143a; forming an organic light-emitting module 32 on the lower electrode layer 31; and forming an upper electrode layer 33 on the organic light-emitting module 32. It should be noted that the organic light-emitting diode display device 30 is controlled by the thin-film transistor T to emit light in a direction toward the substrate 10. That is, the organic light-emitting display device 1 of the embodiment of the present application is a bottom emission type organic light-emitting display device.

In addition, the method of manufacturing the organic light-emitting display device 1 of the embodiment of the present application further includes forming a plurality of the first touch electrodes 12 arranged in rows, and forming a plurality of the second touch electrodes 22 arranged in columns. In some embodiments, there are at least two pixel units configured between adjacent rows of the first touch electrodes 12, and/or there are at least two pixel units configured between adjacent columns of the second touch electrodes 22. In other words, a touch device formed by the first touch electrode 12 and the second touch electrode 22 can be arranged across multiple pixel units (as shown in FIG. 2), which not only achieves an effective touch, but also saves an area as originally needed for touch electrode wirings.

Accordingly, in the organic light-emitting display device and the method of manufacturing the same provided by the embodiments of the present application, a first touch electrode is disposed on a side of a substrate functioning as a light-emitting surface, and a second touch electrode and an active layer are disposed in a same layer. By using a transparent capacitor structure in the OLED display device as a touch device, not only can the need for additional masks for making touch electrodes be prevented, and since a mutual-capacitive touch device is located close to the light-emitting surface, interference from other electrical signals to a touch signal can be greatly reduced. In addition, integrating the touch device in the OLED display device improves a touch effect of the in-cell touch OLED display device. Furthermore, the first touch electrode and the second touch electrode made of transparent materials will not affect the light transmittance of the touch display device, thereby increasing an aperture ratio of the touch display device, maintaining high display performance of the display device, and reducing thickness of the display device, thereby effectively overcoming a technical problem of low aperture ratios, greater thickness of devices, pool light output efficiency, uneven brightness, and poor display effects with current touch organic light-emitting display panels due to provision of touch devices.

In the above-mentioned embodiments, the description of each embodiment has its own emphasis. For parts that are not described in detail in an embodiment, reference may be made to related descriptions of other embodiments.

The above describes the embodiments of the present application in detail. The descriptions of the above embodiments are only used to help understand the technical solutions and kernel ideas of the present disclosure; those of ordinary skill in the art should understand that they can still modify the technical solutions described in the foregoing embodiments, whereas these modifications or substitutions do not deviate the essence of the corresponding technical solutions from the scope of the technical solutions of the embodiments of the present disclosure.

## Claims

1. An organic light-emitting display device, comprising a substrate comprising a plurality of pixel units, each of the pixel units comprising a thin-film transistor and an organic light-emitting diode, OLED, display device, the thin-film transistor comprising a channel portion, a gate electrode, and a source/drain electrode, wherein the organic light-emitting display device further comprises:
a light-shielding layer disposed on the substrate and located under and electrically connected to the thin-film transistor;
at least a first touch electrode, being transparent, and spaced apart from the light-shielding layer on a surface of the substrate on which the light-shielding layer is disposed;
a buffer layer covering the light-shielding layer and the first touch electrode; and
an active layer disposed on the buffer layer and comprising the channel portion of the thin-film transistor and at least a second touch electrode spaced apart from the channel portion, wherein the second touch electrode is disposed opposite to the first touch electrode and is transparent.

2. The organic light-emitting display device of claim 1, further comprising a functional film layer and a pixel definition layer disposed on the functional film layer, and the functional film layer disposed on the buffer layer and covering the thin-film transistor and the second touch electrode, wherein the OLED display device comprises a lower electrode layer, an organic light-emitting module, and an upper electrode layer disposed sequentially from bottom to top, wherein the lower electrode layer is located on a surface of the functional film layer away from the substrate and is electrically connected to the source electrode of the thin-film transistor, and light emitted by the OLED display device is emitted in a direction toward the substrate.

3. The organic light-emitting display device of claim 2, wherein the lower electrode layer is a transparent cathode layer, the upper electrode layer is an anode layer, and the lower electrode layer is connected to the light-shielding layer through the source electrode, wherein an orthographic projection of the light-shielding layer on the substrate covers orthographic projections of the channel portion and the source electrode on the substrate.

4. The organic light-emitting display device of claim 1, wherein the channel portion of the thin-film transistor comprises a semiconductor channel and contact portions located at two ends of the semiconductor channel, a gate insulating layer is disposed on a side of the semiconductor channel away from the buffer layer, and the gate electrode is disposed on the gate insulating layer, wherein the drain electrode is connected to one of the contact portions, and the source electrode is connected to the other contact portion.

5. The organic light-emitting display device of claim 1, further comprising a plurality of the first touch electrodes and a plurality of the second touch electrodes, and the pixel units are arranged in an array, wherein the first touch electrodes are arranged in rows and the second touch electrodes are arranged in columns.

6. The organic light-emitting display device of claim 5, wherein there are at least two of the pixel units configured between adjacent rows of the first touch electrodes, and/or there are at least two of the pixel units configured between adjacent columns of the second touch electrodes.

7. A method of manufacturing an organic light-emitting display device, comprising forming a plurality of pixel units arranged in an array on a substrate, and each of the pixel units comprises a thin-film transistor and an organic light-emitting diode display device, wherein the manufacturing method further comprises:
forming a light-shielding layer on the substrate;
forming, using a transparent metal material, at least a first touch electrode spaced apart from the light-shielding layer on a surface of the substrate provided with the light-shielding layer;
forming a buffer layer on the substrate such that the buffer layer covers the light-shielding layer and the first touch electrode;
depositing an active layer on the buffer layer and patterning the active layer to form a channel portion and a touch area corresponding to the first touch electrode;
forming a second touch electrode in the active layer corresponding to the touch area, and forming a semiconductor channel and contact portions in the channel portion;
forming a functional film layer and the thin-film transistor on the buffer layer provided with the second touch electrode and the channel portion; and
forming a pixel definition layer and the organic light-emitting diode display device on the functional film layer.

8. The method of manufacturing the organic light-emitting display device of claim 7, wherein the step of forming the second touch electrode in the active layer corresponding to the touch area comprises:
performing an electrically conductive treatment on a portion of the active layer corresponding to the touch area by a dry process to form the second touch electrode;
wherein the step of forming the functional film layer and the thin-film transistor on the buffer layer provided with the second touch electrode and the channel portion comprises: forming a plurality of contact holes in the functional film layer, so that a source electrode included in the thin-film transistor is connected to the light-shielding layer through one of the contact holes, and a drain electrode and the source electrode included in the thin-film transistor are connected to two ends of the channel portion through the other contact holes.

9. The method of manufacturing the organic light-emitting display device of claim 8, wherein the step of forming the pixel definition layer and the organic light-emitting diode display device on the functional film layer comprises:
forming a via hole in the functional film layer, and the via hole extending through part of the functional film layer to the source electrode of the thin-film transistor;
forming a transparent lower electrode layer on a surface of the functional film layer away from the substrate, wherein the lower electrode layer is connected to the source electrode of the thin-film transistor through the via hole;
forming an organic light-emitting module on the lower electrode layer; and
forming an upper electrode layer on the organic light-emitting module;
wherein the organic light-emitting diode display device is controlled by the thin-film transistor to emit light in a direction toward the substrate.

10. The method of manufacturing the organic light-emitting display device of claim 7, further comprising:
forming a plurality of the first touch electrodes arranged in rows; and
forming a plurality of the second touch electrodes arranged in columns;
wherein there are at least two of the pixel units configured between adjacent rows of the first touch electrodes, and/or there are at least two of the pixel units configured between adjacent columns of the second touch electrodes.

11. An organic light-emitting display device, comprising a substrate comprising a plurality of pixel units, each of the pixel units comprising a thin-film transistor and an organic light-emitting diode, OLED, display device, the thin-film transistor comprising a channel portion, a gate electrode, and a source/drain electrode, wherein the organic light-emitting display device further comprises:
a light-shielding layer disposed on the substrate and located under the thin-film transistor and electrically connected to the thin-film transistor;
at least a first touch electrode, being transparent, and spaced apart from the light-shielding layer on a surface of the substrate on which the light-shielding layer is disposed;
a buffer layer covering the light-shielding layer and the first touch electrode; and
a functional film layer disposed on the buffer layer;
a pixel definition layer disposed on the functional film layer; and
an active layer disposed on the buffer layer and comprising the channel portion of the thin-film transistor and at least a second touch electrode spaced apart from the channel portion, wherein the second touch electrode is disposed opposite to the first touch electrode and overlaps the first touch electrode with respect to the buffer layer, and the second touch electrode is transparent;
wherein the functional film layer covers the thin-film transistor and the second touch electrode, and the organic light-emitting diode display device comprises a lower electrode layer, an organic light-emitting module, and an upper electrode layer disposed sequentially from bottom to top, wherein the lower electrode layer is located on a surface of the functional film layer away from the substrate and is electrically connected to the source electrode of the thin-film transistor, and light emitted by the organic light-emitting diode display device is emitted in a direction toward the substrate.

12. The organic light-emitting display device of claim 11, wherein the lower electrode layer is a transparent cathode layer, the upper electrode layer is an anode layer, and the lower electrode layer is connected to the light-shielding layer through the source electrode, wherein an orthographic projection of the light-shielding layer on the substrate covers orthographic projections of the channel portion and the source electrode on the substrate.

13. The organic light-emitting display device of claim 11, wherein the channel portion of the thin-film transistor comprises a semiconductor channel and contact portions located at two ends of the semiconductor channel, a gate insulating layer is disposed on a side of the semiconductor channel away from the buffer layer, and the gate electrode is disposed on the gate insulating layer, wherein the drain electrode is connected to one of the contact portions, and the source electrode is connected to the other contact portion.

14. The organic light-emitting display device of claim 11, further comprising a plurality of the first touch electrodes and a plurality of the second touch electrodes, and the pixel units are arranged in an array, wherein the first touch electrodes are arranged in rows and the second touch electrodes are arranged in columns.

15. The organic light-emitting display device of claim 14, wherein there are at least two of the pixel units configured between adjacent rows of the first touch electrodes, and/or there are at least two of the pixel units configured between adjacent columns of the second touch electrodes.
